# FASCICULE DE BREVET EUROPEEN

(11) **EP 1 614 765 B1**
(45) Date de publication et mention de la délivrance du brevet: **01.10.2008**
(21) Numéro de dépôt: 05106104.2
(22) Date de dépôt: 05.07.2005
(51) Int. Cl.: C23C 14/06, C23C 14/34, C30B 29/02, C30B 29/66

(54) **Croissance à basse températurede nanotubes de carbone orientés**
Niedertemperaturwachstum orientierter Kohlenstoff-Nanoröhrchen
Low temperature growth of oriented carbon nanotubes

(30) Priorité: 07.07.2004 FR 0407529
(43) Date de publication de la demande: 11.01.2006
(73) Titulaire: COMMISSARIAT A L'ENERGIE ATOMIQUE, 75015 Paris (FR)
(72) Inventeur: Dijon, Jean, 38800 Champagnier (FR); Le Poche, Hélène, 38000 Grenoble (FR); Goislard de Monsabert, Thomas, 38330, Saint Ismier (FR)
(74) Mandataire: Poulin, Gérard

(56) Documents cités:
- WO-A-02/059392
- WO-A-03/046255
- WO-A-20/04027108
- DE-A- 19 946 182
- US-A1- 2002 160 111
- LEE K-Y ET AL: "METHOD FOR ALIGNED BAMBOOLIKE CARBON NANOTUBE GROWTH USING RF MAGNETRON SPUTTERING" JAPANESE JOURNAL OF APPLIED PHYSICS, PUBLICATION OFFICE JAPANESE JOURNAL OF APPLIED PHYSICS. TOKYO, JP, vol. 42, no. 2A, PART 1, février 2003 (2003-02), pages 713-715, XP001164841 ISSN: 0021-4922

## Description

### DOMAINE TECHNIQUE

L'invention se rapporte à la croissance à basse température de nanotubes de carbone orientés.

### ÉTAT DE LA TECHNIQUE ANTÉRIEURE

De nombreux procédés de fabrication de nanotubes de carbone (CNT) ont été proposés. On peut les classer en deux catégories : les procédés produisant des matériaux en vrac et les procédés produisant des nanotubes sur des surfaces ou sur des composants.

Dans la première catégorie, on trouve :
- les premières synthèses réalisées à haute température par arc (S.IIJIMA, « Helical Microtubules of Graphitic Carbon », Nature 354, 56, 1991) ;
- les synthèses par laser (T.GUO et al., « Self-Assembly of Tubular Fullerenes », J. Phys. Chem 99, 10 694, 1995) ;
- les synthèses électrochimiques (W.K. HSU et al., Nature 377, 687, 1995) ;
- les synthèses pyrolytiques (M. ENDO et al. « Pyrolytic Carbon Nanotubes from Vapor Grown Carbon fiber », Carbon 33, p. 873, 1995).

Dans la deuxième catégorie, on trouve les procédés de synthèse catalytique utilisant un dépôt CVD thermique, un dépôt CVD thermique assisté par filament chaud ou un dépôt CVD thermique assisté par plasma (M. MEYYAPPAN et al., « Carbon Nanotube Growth by PECVD : A Review » Plasma Sources Sci. Technol. 12 (mai 2003) 205-216). Dans tous les cas, l'apport de carbone se fait grâce à un gaz réactif hydrocarbure (C₂H₂, CH₄...) ou monoxyde de carbone.

Les procédé utilisant la pulvérisation cathodique radiofréquence d'une cible de graphite ne marchent pas sans l'ajout d'un filament chauffé à 2000°C. Les espèces en provenance de la cible ne permettent pas d'obtenir la croissance de nanotubes. L'ajout d'un filament chaud provoque le craquage des espèces et les rend efficaces pour réagir sur un catalyseur (K. LEE et al., « Method for aligned bamboolike carbon nanotubes growth using RF magnetron sputtering », Jpn J. Appl. Phys., Vol. 42 (2003), p. 713-715).

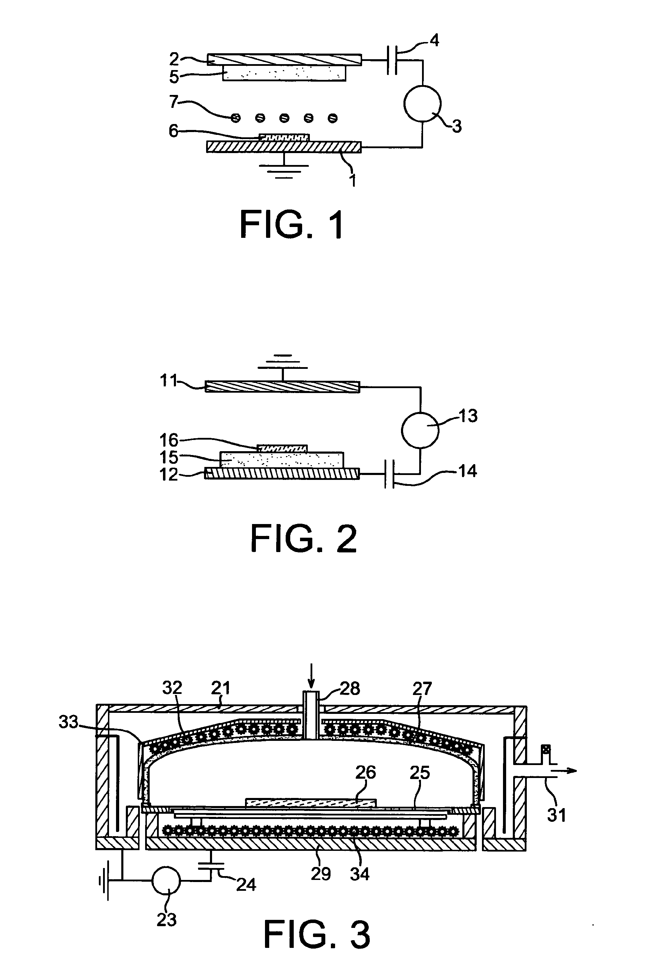

La figure 1 est une vue schématique d'un dispositif de pulvérisation RF suivant l'art connu, permettant la croissance de nanotubes de carbone. Le dispositif comprend, dans une enceinte de dépôt, une première électrode 1 (cathode) faisant office de porte-échantillon et une deuxième électrode 2 (anode) placée en vis-à-vis. Un générateur RF 3, connecté en série avec un condensateur 4, permet de fournir une tension RF entre les électrodes 1 et 2. L'électrode 2 supporte, sur sa face située en regard de l'électrode 1, une cible en graphite 5. L'électrode 1 supporte, sur sa face située en regard de l'électrode 2, un échantillon 6 destiné à recevoir un dépôt de nanotubes. Entre la cible 5 et l'échantillon 6 est disposée, à proximité de l'échantillon, un filament 7 porté à la température requise pour obtenir le craquage du graphite provenant de la cible.

### EXPOSÉ DE L'INVENTION

La présente invention permet la croissance de nanotubes de carbone verticaux sur des surfaces ou des dispositifs en utilisant une cible de carbone solide, sans ajout de filament chaud.

L'invention a donc pour objet un procédé de croissance de nanotubes de carbone orientés sur un échantillon utilisant une cible de carbone ou une variété de carbone dans une enceinte de dépôt où règne un plasma, caractérisé en ce que l'échantillon est disposé au contact de la cible, de façon que la cible présente une surface libre et que l'échantillon offre une surface libre, la surface libre offerte par l'échantillon supportant, au moins partiellement, une couche catalytique, le plasma provoquant la croissance de nanotubes de carbone sur la surface libre de l'échantillon.

Le plasma peut être un plasma d'hydrogène. Il peut être un plasma d'un mélange gazeux comprenant de l'hydrogène. Le mélange gazeux peut comprendre au moins un gaz rare, choisi par exemple parmi l'argon, le krypton et le xénon. Il peut comprendre de l'azote ou de l'ammoniac. Il peut comprendre un gaz carboné comme CO ou l'acétylène.

Le procédé peut être réalisé à une température supérieure à 300°C.

Selon un mode de mise en oeuvre particulier, la surface libre de la cible présente une forme de grille.

La cible peut consister en un dépôt effectué sur l'échantillon.

Le procédé selon l'invention peut s'appliquer à la croissance de nanotubes de carbone sur un substrat en matériau semiconducteur ou en verre. Il peut aussi être utiliser pour obtenir la croissance de nanotubes de carbone orientés au fond de cavités triodes d'une plaque émettrice à émission de champ, les nanotubes de carbone constituant alors des sources émettrices d'électrons.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1, déjà décrite, est une vue schématique d'un dispositif de pulvérisation RF permettant la croissance de nanotubes de carbone selon l'art connu ;
- la figure 2 est une vue schématique d'un dispositif permettant la croissance de nanotubes de carbone selon l'invention ;
- la figure 3 est un schéma en coupe transversale d'une enceinte de dépôt permettant de mettre en oeuvre le procédé selon l'invention ;
- la figure 4 est une vue en coupe d'un arrangement particulier de la cible et de l'échantillon utilisés pour la présente invention ;
- la figure 5 est une photographie obtenue par microscopie électronique à balayage de nanotubes de carbone obtenus par le procédé selon l'invention ;
- la figure 6 est une vue en coupe d'une cavité triode d'une plaque émettrice à émission de champ dont la source émettrice d'électrons est constituée de nanotubes de carbones obtenus par le procédé selon l'invention ;
- la figure 7 est une autre photographie obtenue par microscopie électronique à balayage de nanotubes de carbone obtenus par le procédé selon l'invention.

### EXPOSÉ DÉTAILLÉ DE MODES DE RÉALISATION PARTICULIERS

La figure 2 est une vue schématique d'un dispositif permettant la croissance de nanotubes de carbone selon l'invention. Le dispositif comprend, dans une enceinte de dépôt, une première électrode 11 (cathode) et une deuxième électrode 12 (anode) placées en vis-à-vis. Un générateur RF 13, connecté en série avec un condensateur 14, permet de fournir une tension RF entre les électrodes 11 et 12. L'électrode 12 supporte en empilement, sur sa face située en regard de l'électrode 11, une cible en graphite 15 et un échantillon 16 destiné à recevoir un dépôt de nanotubes. La cible 15 présente une surface libre, c'est-à-dire non recouverte par l'échantillon et l'échantillon 16 offre une surface libre pour la croissance des nanotubes. Dans l'enceinte règne un plasma d'hydrogène. La cible 15 fournit l'apport en carbone par l'intermédiaire du bombardement des ions de plasma. L'échantillon comporte, sur sa surface libre, un dépôt catalytique. Parmi les catalyseurs connus de l'homme du métier, on peut citer le fer, le cobalt, le nickel, le platine et le molybdène. La croissance des nanotubes se localise alors sur le catalyseur. Le dépôt se fait à une température typiquement supérieure à 300°C. Le gaz servant à obtenir le plasma peut être de l'hydrogène pur. Ce peut être également un mélange gazeux comprenant de l'hydrogène et un ou plusieurs gaz rares choisis par exemple parmi l'argon le krypton et le xénon. Le mélange peut également contenir de l'azote ou de l'ammoniac connu pour agir au niveau de cristal de carbone. Il peut également contenir un gaz carboné comme du CO ou de l'acétylène.

La figure 3 est un schéma en coupe transversale d'une enceinte de dépôt permettant de mettre en oeuvre le procédé selon l'invention. Cette enceinte permet la réalisation d'un vide secondaire. Dans cette enceinte, une cloche en quartz 27 permet de limiter la zone réactionnelle où le plasma est réalisé. Cette cloche 27 permet l'introduction de gaz par une entrée de gaz 28. La cloche repose sur une sole 29 isolée électriquement du bâti 21. Un générateur RF 23, connecté en série avec un condensateur 24, permet de fournir une tension RF entre le bâti 21, servant de cathode, et la sole 29, servant d'anode. Une sortie de gaz 31 permet de pomper l'intérieur du bâti 21. Un premier dispositif de chauffage 32 est disposé au-dessus de la cloche 27 et sous un réflecteur thermique 33. Un deuxième dispositif de chauffage 34, placé en position basse, permet de chauffer la cible en graphite 25. La cible 25 repose sur la sole 29 et supporte un échantillon 26 (ou plusieurs échantillons). La cible et l'échantillon sont donc au même potentiel électrique.

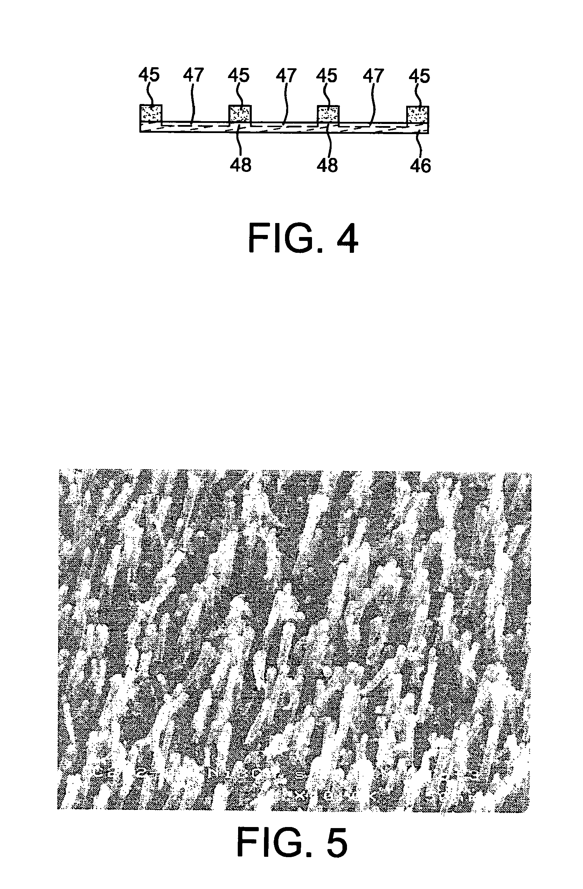

La figure 4 est une vue en coupe d'un arrangement particulier d'une cible en graphite 45, en forme de grille disposée sur un échantillon 46. L'échantillon 46 est par exemple une plaquette de silicium de 200 ou 300 mm de diamètre. Cette plaquette comporte des zones actives 47 devant recevoir des nanotubes de carbone et séparées par des chemins de découpe 48 (typiquement de 0,5 mm de largeur).

Plutôt que de déposer une cible en graphite grillagée sur une plaquette servant d'échantillon, il est possible d'intégrer la cible à l'échantillon. Ceci peut être obtenu en effectuant un dépôt de matériau cible sur les chemins de découpe de la plaquette, ou sur les zones non actives de la plaquette.

### Exemple de réalisation N°1

Selon ce premier exemple de réalisation, les échantillons comprennent un multicouche de matériaux déposé sur un substrat en silicium. Sur le substrat, on trouve successivement une couche de titane de 60 nm d'épaisseur, une couche de TiN de 65 nm d'épaisseur et une couche de nickel de 3 nm d'épaisseur.

L'échantillon est placé dans l'enceinte réactionnelle représentée à la figure 3. Dans cette enceinte, l'échantillon est soumis à une température de 500°C, sous une pression de 150 mTorr (20 Pa) d'hydrogène et pendant 20 minutes. Un plasma d'hydrogène pur est alors réalisé avec une puissance de 300 W à la pression de 150 mTorr (20 Pa). La phase de dépôt des nanotubes de carbone est réalisée pendant 1 heure.

La figure 5 est une photographie, obtenue par microscopie électronique à balayage, des nanotubes obtenus. Ces nanotubes sont verticaux. Ils présentent un diamètre moyen de 36 nm et une hauteur de 400 nm. La sélectivité du dépôt est excellente. Aucun dépôt carboné parasite n'est observé en dehors des grains de catalyseur.

### Exemple de réalisation N°2

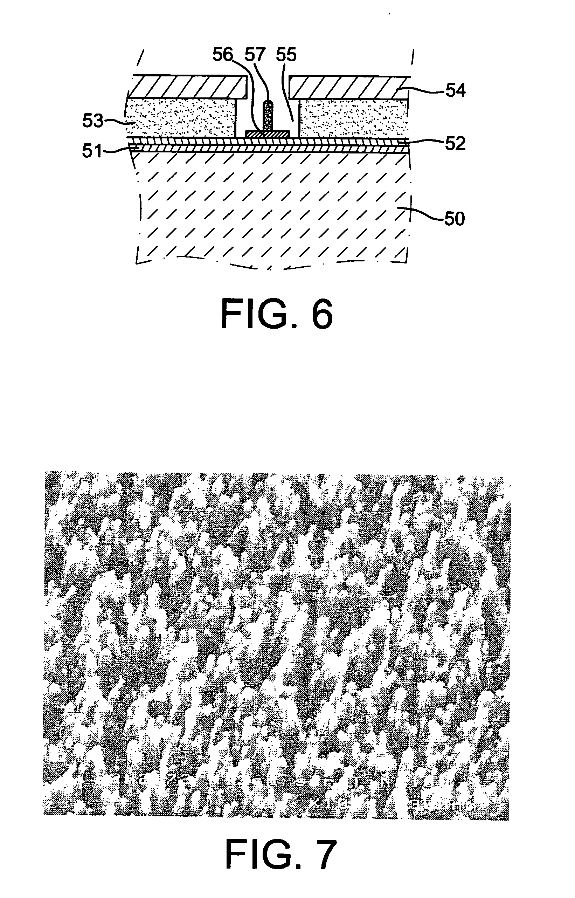

Selon ce deuxième exemple de réalisation, les échantillons comprennent un multicouche de matériaux déposé sur un substrat en silicium. Sur ce substrat, on réalise des structures triodes de la manière suivante, en relation avec la figure 6. On dépose successivement sur un substrat 50, une couche 51 de titane de 60 nm d'épaisseur, une couche 52 de TiN de 65 nm d'épaisseur, une couche d'isolant 53 (en oxyde de silicium par exemple) de 300 nm d'épaisseur et une autre couche 54 de TiN de 200 nm d'épaisseur. Par une opération de gravure, des cavités sont ouvertes jusqu'à la couche 52 de TiN qui joue le rôle de conducteur cathodique. La figure 6 ne montre qu'une seule cavité 55. Une pastille de nickel 56 de 3 nm d'épaisseur est alors localisée par photolithographie au fond de la cavité 55 et en son centre.

L'échantillon est placé dans l'enceinte réactionnelle représentée à la figure 3. Dans cette enceinte, l'échantillon est soumis à une température de 500°C, sous une pression de 150 mTorr (20 Pa) d'hydrogène pur et pendant 20 minutes. A la même pression, un plasma contenant 25 % d'argon et 75 % d'hydrogène est alors réalisé avec une puissance de 300 W. La phase de dépôt des nanotubes de carbone est réalisée pendant 1 heure. Il se forme alors un élément 57 en forme de tige, obtenu par croissance verticale de nanotubes de carbone. L'élément 57 constitue une source émettrice d'électrons, les couches 51 et 52 jouant le rôle de conducteurs cathodiques et la couche 54 jouant le rôle de grille d'extraction.

L'homme du métier pourrait remplacer l'argon par un autre gaz connu pour favoriser la pulvérisation comme le xénon ou encore le krypton par exemple.

### Exemple de réalisation N°3

Selon ce troisième exemple de réalisation, les échantillons comprennent un multicouche de matériaux déposé sur un substrat en verre au borosilicate. Sur ce substrat, on trouve successivement une couche de molybdène de 200 nm d'épaisseur, une couche de silicium amorphe de 1,4 µm d'épaisseur, une couche de TiN de 65 nm d'épaisseur et une couche de nickel de 3 nm d'épaisseur.

L'échantillon est placé dans l'enceinte réactionnelle représentée à a figure 3. Dans cette enceinte, l'échantillon est soumis à une température de 500°C, sous une pression de 150 mTorr (20 Pa) d'hydrogène et pendant 20 minutes. Un plasma d'hydrogène pur est alors réalisé à la même pression avec une puissance de 300 W pendant 10 minutes. Puis, un plasma contenant 95 % d'hydrogène et 5 % d'acétylène est réalisé pendant 15 minutes.

La figure 7 est une photographie, obtenue par microscopie électronique à balayage, des nanotubes obtenus.

## Revendications

1. Procédé de croissance de nanotubes de carbone orientés sur un échantillon (16, 26, 46) utilisant une cible de carbone ou une variété de carbone (15, 25, 45) dans une enceinte de dépôt où règne un plasma, **caractérisé en ce que** l'échantillon est disposé au contact de la cible, de façon que la cible présente une surface libre et que l'échantillon offre une surface libre, la surface libre offerte par l'échantillon supportant, au moins partiellement, une couche catalytique, le plasma provoquant la croissance de nanotubes de carbone sur la surface libre de l'échantillon.

2. Procédé selon la revendication 1, **caractérisé en ce que** le plasma est un plasma d'hydrogène.

3. Procédé selon la revendication 1, **caractérisé en ce que** le plasma est un plasma d'un mélange gazeux comprenant de l'hydrogène.

4. Procédé selon la revendication 3,
**caractérisé en ce que** le mélange gazeux comprend au moins un gaz rare.

5. Procédé selon la revendication 4, **caractérisé en ce que** ledit gaz rare est choisi parmi l'argon, le krypton et le xénon.

6. Procédé selon l'une quelconque des revendications 3 à 5, **caractérisé en ce que** le mélange gazeux comprend de l'azote ou de l'ammoniac.

7. Procédé selon l'une quelconque des revendications 3 à 6, **caractérisé en ce que** le mélange gazeux comprend un gaz carboné.

8. Procédé selon la revendication 7, **caractérisé en ce que** le gaz carboné est choisi parmi CO et l'acétylène.

9. Procédé selon l'une quelconque des revendications 1 à 8, **caractérisé en ce qu'**il est réalisé à une température supérieure à 300°C.

10. Procédé selon l'une quelconque des revendications 1 à 9, **caractérisé en ce que** la surface libre de la cible (45) présente une forme de grille.

11. Procédé selon l'une quelconque des revendications 1 à 10, **caractérisé en ce que** la cible consiste en un dépôt effectué sur l'échantillon.

12. Application du procédé selon l'une quelconque des revendications 1 à 11 à la croissance de nanotubes de carbone sur un substrat en matériau semiconducteur ou en verre.

13. Application du procédé selon l'une quelconque des revendications 1 à 11 pour obtenir la croissance de nanotubes de carbone orientés au fond de cavités triodes d'une plaque émettrice à émission de champ, les nanotubes de carbone (57) constituant alors des sources émettrices d'électrons.

## Claims

1. Method for growing oriented carbon nanotubes on a sample (16, 26, 46) using a target of carbon or variety of carbon (15, 25, 45) in a deposition chamber where a plasma predominates, **characterised in that** the sample is arranged in contact with the target, in such a way that the target has a free surface and that the sample offers a free surface, the free surface offered by the sample supporting, at least partially, a catalytic layer, the plasma causing the growth of carbon nanotubes on the free surface of the sample.

2. Method according to claim 1, **characterised in that** the plasma is a hydrogen plasma.

3. Method according to claim 1, **characterised in that** the plasma is a plasma of a gaseous mixture comprising hydrogen.

4. Method according to claim 3, **characterised in that** the gaseous mixture comprises at least one noble gas.

5. Method according to claim 4, **characterised in that** said noble gas is chosen from among argon, krypton and xenon.

6. Method according to any of claims 3 to 5, **characterised in that** the gaseous mixture comprises nitrogen or ammonia

7. Method according to any of claims 3 to 6, **characterised in that** the gaseous mixture comprises a carbonated gas.

8. Method according to claim 7, **characterised in that** the carbonated gas is chosen from among CO and acetylene.

9. Method according to any of claims 1 to 8, **characterised in that** it is carried out at a temperature above 300°C.

10. Method according to any of claims 1 to 9, **characterised in that** the free surface of the target (45) has a grid shape.

11. Method according to any of claims 1 to 10, **characterised in that** the target consists in a deposit carried out on the sample.

12. Application of the method according to any of claims 1 to 11 to the growth of carbon nanotubes on a substrate in semiconductor material or in glass.

13. Application of the method according to any of claims 1 to 11 to obtain the growth of oriented carbon nanotubes at the base of triode cavities of a field emitting emission plate, said carbon nanotubes (57) then constituting electron emission sources.

## Patentansprüche

1. Wachstumsverfahren orientierter Kohlenstoff-Nanoröhrchen auf einem Muster (16, 26, 46) unter Verwendung eines Targets aus Kohlenstoff oder einer Kohlenstoffvarietät (15, 25, 45) in einem Abscheidungsbehälter, in dem ein Plasma herrscht,
**dadurch gekennzeichnet, dass** das Muster mit Kontakt zum Target so angeordnet ist, dass das Target eine freie Oberfläche aufweist und das Muster eine freie Oberfläche aufweist, wobei die freie Oberfläche des Musters wenigstens partiell eine katalytische Schicht aufweist und das Plasma auf der freien Oberfläche des Musters das Wachstum von Kohlenstoff-Nanoröhrchen bewirkt.

2. Verfahren nach Anspruch 1, **dadurch gekennzeichnet, dass** das Plasma ein Wasserstoffplasma ist.

3. Verfahren nach Anspruch 1, **dadurch gekennzeichnet, dass** das Plasma ein Plasma einer gasförmigen Mischung ist, die Wasserstoff umfasst.

4. Verfahren nach Anspruch 3, **dadurch gekennzeichnet, dass** die gasförmige Mischung wenigstens ein Edelgas enthält.

5. Verfahren nach Anspruch 4, **dadurch gekennzeichnet, dass** das genannte Edelgas ausgewählt wird unter Argon, Krypton und Xenon.

6. Verfahren nach einem der Ansprüche 3 bis 5, **dadurch gekennzeichnet, dass** die gasförmige Mischung Stickstoff oder Ammoniak enthält.

7. Verfahren nach einem der Ansprüche 3 bis 6, **dadurch gekennzeichnet, dass** die gasförmige Mischung ein kohlenstoffhaltiges Gas enthält.

8. Verfahren nach Anspruch 7, **dadurch gekennzeichnet, dass** das kohlenstoffhaltige Gas ausgewählt wird zwischen CO und Azetylen.

9. Verfahren nach einem der Ansprüche 1 bis 8, **dadurch gekennzeichnet, dass** es mit einer Temperatur von über 300 °C realisiert wird.

10. Verfahren nach einem der Ansprüche 1 bis 9, **dadurch gekennzeichnet, dass** die freie Oberfläche des Musters (45) eine Gitterform aufweist.

11. Verfahren nach einem der Ansprüche 1 bis 10, **dadurch gekennzeichnet, dass** das Target durch eine auf dem Muster erzeugte Abscheidung gebildet wird.

12. Anwendung des Verfahrens nach einem der Ansprüche 1 bis 11 zur Realisierung des Wachstums von Kohlenstoff-Nanoröhrchen auf einem Substrat aus Halbleitermaterial oder Glas.

13. Anwendung des Verfahrens nach einem der Ansprüche 1 bis 11, um das Wachstum orientierter Kohlenstoff-Nanoröhrchen am Boden von Trioden-Hohlräumen eines emittierenden Feldemissionsplättchens zu realisieren, wobei die Kohlenstoff-Nanoröhrchen (57) dann Elektronenemissionsquellen bilden.
